# EUROPEAN PATENT APPLICATION

(11) **EP 4 280 416 A1**
(43) Date of publication of application: **22.11.2023**
(21) Application number: 22833356.3
(22) Date of filing: 21.03.2022
(51) Int. Cl.: H02J 7/00, H02J 50/10, G01K 1/02, G01R 31/382, G01R 19/165, H01M 10/48

(54) **CHARGING METHOD BASED ON THERMAL CONTROL, AND ELECTRONIC DEVICE THEREFOR**

(30) Priority: 28.06.2021 KR 20210084335; 12.07.2021 KR 20210090799
(71) Applicant: Samsung Electronics Co., Ltd., Suwon-si, Gyeonggi-do 16677 (KR)
(72) Inventor: CHOI, Yongjun, Suwon-si, Gyeonggi-do 16677 (KR); PARK, Youngjoon, Suwon-si, Gyeonggi-do 16677 (KR)
(74) Representative: HGF
(86) International application number: PCT/KR2022/003919
(87) International publication number: WO 2023/277300

(57) **Abstract**

According to various embodiments, an electronic device comprises a housing, a battery, at least one sensor, a charging circuit, and at least one processor, wherein the at least one processor can be configured to: charge the battery with a first charging current through the charging circuit; while charging the battery with the first charging current, measure the temperature associated with the electronic device by using the at least one sensor, and lower the first charging current to a second charging current on the basis of the temperature associated with the electronic device that is higher than or equal to a first threshold temperature, so as to charge the battery; while charging the battery with the second charging current, lower the first charging current on the basis of the temperature associated with the electronic device being lower than a second threshold temperature that is lower than the first threshold temperature, so as to charge the battery; and charge the battery with the lowered first charging current on the basis of the number of times the first charging current is lowered and the temperature associated with the electronic device that is lower than the first threshold temperature. Other various embodiments can be provided.

## Description

### [Technical Field]

The disclosure relates to a charging method based on heat generation control, and an electronic device therefor.

### [Background Art]

An electronic device (for example, portable terminal) may process various functions such as communication and multimedia. The electronic device may include a large-capacity battery to perform various functions. The electronic device may use wired charging or wireless charging to charge the battery of the electronic device.

Recently, a large number of electronic devices use wireless power transfer technologies for wireless charging or contactless charging. Wireless power transfer refers to a technology for converting electric energy into an electromagnetic wave having a frequency and wirelessly transferring energy to a load without a transfer line. According to the wireless power transfer technology, power may be wirelessly transferred from a power transmitting device to a power receiving device without wired connection between the power transmitting device and the power receiving device, thereby charging the battery of the power receiving device. The wireless power transfer technology may include magnetic induction, magnetic resonance, and electromagnetic wave types, and various other types of wireless power transfer technology may exist.

### [Detailed Description of the Invention]

### [Technical Problem]

In order for electronic devices to perform various functions, portable terminals include an increased number of processors, have higher maximum clocks and larger displays, output brighter screens, and are equipped with high-pixel camera modules and the like, thereby having increased causes of heat generation. An electronic device may include a large-capacity battery to perform various functions, the charging current may be increased to charge the large-capacity battery faster, and heat may be generated when the electronic device performs wired or wireless charging.

When an electronic device performs charging, the electronic device corresponding to the charging target may monitor the temperature during charging and may stop receiving power if the temperature exceeds a configured temperature. As such, a temperature rise may stop charging, and a temperature drop may resume charging, but the charging time may be prolonged.

Particularly, a wearable device may perform constant charging at a low charging temperature (for example, 0.5C) such that an over temperature situation does not occur, in view of the risk of low-temperature burn due to skin contact while the device is worn. safety is given higher priority than the charging speed in the case of such a wearable device.

Embodiments of the disclosure may provide a charging method based on heat generation control and an electronic device therefore, wherein, in view of both charging speed and safety, fast battery charging can be provided during charging.

Technical problems to be addressed by the disclosure are not limited to the above-mentioned technical problems, and other technical problems not mentioned herein will be clearly understood from the following description by those skilled in the art to which the disclosure pertains.

### [Technical Solution]

According to various example embodiments, an electronic device may include: a housing, a battery, at least one sensor, a charging circuit, and at least one processor, wherein the at least one processor is configured to: control the charging circuit to charge the battery with a first charging current through the charging circuit, measure a temperature associated with the electronic device using the at least one sensor while charging the battery with the first charging current, based on the temperature associated with the electronic device being equal to or higher than a first threshold temperature, decrease the first charging current to be a second charging current and charge the battery with the second charging current, and based on the temperature associated with the electronic device being below a second threshold temperature lower than the first threshold temperature while charging the battery with the second charging current, decrease the first charging current and charge the battery with the decreased charging current, and wherein the battery is configured to be charged with the first charge current decreased based on the number of times the first charging current has been decreased, the temperature associated with the electronic device being below the first threshold temperature.

According to various example embodiments, a charging method based on heat generation control in an electronic device may include: charging a battery of the electronic device with a first charging current through a charging circuit, measuring a temperature associated with the electronic device using at least one sensor of the electronic device while charging the battery with the first charging current, based on the temperature associated with the electronic device being equal to or higher than a first threshold temperature, decreasing the first charging current to be a second charging current and charging the battery with the second charging current, and based on the temperature associated with the electronic device being below a second threshold temperature lower than the first threshold temperature while charging the battery with the second charging current, decreasing the first charging current and charging the battery with the decreased charging current, wherein the charging of the battery is performed with the first charge current decreased based on the number of times the first charge current has been decreased, the temperature associated with the electronic device being below the first threshold temperature.

According to various example embodiments, an electronic device may include: a housing, a battery, at least one sensor, a charging circuit, and at least one processor, wherein the at least one processor is configured to: control the charging circuit to charge the battery with a first charging current through the charging circuit, measure a temperature associated with the electronic device using the at least one sensor while charging the battery with the first charging current, based on the temperature associated with the electronic device being equal to or higher than a first threshold temperature, decrease the first charging current to be a second charging current and charge the battery with the second charging current, and based on the temperature associated with the electronic device being below a second threshold temperature lower than the first threshold temperature while charging the battery with the second charging current, charge the battery with a third charging current lower than the first charging current.

### [Technical Solution]

According to various example embodiments, in the case of a wearable device, the charging current may be controlled step by step so as to ensure both charging speed and stable charging such that fast battery charging can be provided during wired or wireless charging.

According to various example embodiments, the charging time may be reduced in the case of a wearable device, and heat generation may be controlled to prevent and/or reduce low-temperature burn accidents due to skin contact.

Advantageous effects obtainable from the disclosure are not limited to the above-mentioned advantageous effects, and other advantageous effects not mentioned herein will be clearly understood by those skilled in the art to which the present disclosure pertains.

### [Brief Description of Drawings]

The above and other aspects, features and advantages of certain embodiments of the present disclosure will be more apparent from the following detailed description, taken in conjunction with the accompanying drawings, in which:
FIG. 1 is a block diagram illustrating an example electronic device in a network environment according to various embodiments;
FIG. 2 illustrates a block diagram illustrating an example configuration of a wireless power transmitter and an electronic device according to various embodiments;
FIG. 3 is a diagram illustrating a state in which an electronic device is placed on a charging pad for wireless charging according to various embodiments;
FIG. 4 is a graph illustrating an example charging operation of a battery of a wearable device based on a charging current according to various embodiments;
FIG. 5A is an exploded perspective view illustrating an electronic device according to various embodiments;
FIG. 5B is a cross-sectional view of an electronic device according to various embodiments;
FIG. 6 is a block diagram illustrating an example configuration of an electronic device according to various embodiments;
FIG. 7A, 7B, and 7C are graphs illustrating an example fast charging operation of a battery of a wearable device based on a charging current according to various embodiments;
FIG. 8 is a flowchart illustrating an example operation of an electronic device for fast charging based on heat generation control according to various embodiments;
FIG. 9 is a flowchart illustrating an example operation of an electronic device for fast charging when one thermistor is used according to various embodiments;
FIG. 10 is a flowchart illustrating an example operation of an electronic device for fast charging when two thermistors are used according to various embodiments;
FIG. 11 is a flowchart illustrating an example operation of an electronic device for fast charging when one of two thermistors is used according to various embodiments;
FIG. 12 is a graph illustrating an example measurement result according to heat generation control during fast charging according to various embodiments; and
FIG. 13 is a diagram illustrating an example charging screen of an electronic device corresponding to a fast charging method according to various embodiments.

In connection with the description of drawings, the same or similar reference numerals may be used for indicating the same or similar elements.

### [Mode for Carrying out the Invention]

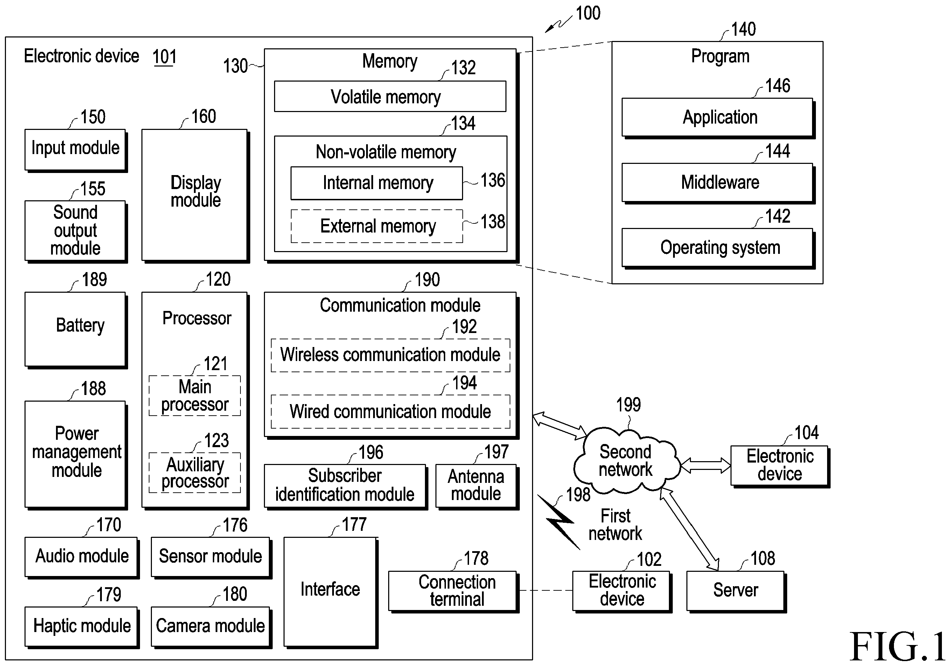

FIG. 1 is a block diagram illustrating an example electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In various embodiments, at least one of the components (e.g., the connecting terminal 178) may be omitted from the electronic device 101, or one or more other components may be added in the electronic device 101. In various embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active (e.g., executing an application) state. According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence model is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or an external electronic device (e.g., an electronic device 102 (e.g., a speaker or a headphone)) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example.

The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

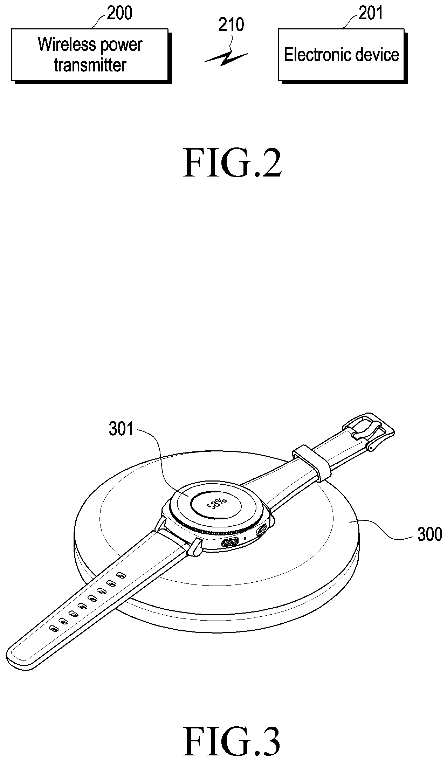

FIG. 2 is a block diagram illustrating an example configuration of a wireless power transmitter and an electronic device according to various embodiments.

Referring to FIG. 2, a wireless power transmitter (e.g., including wireless power transmitting circuitry) 200 according to various embodiments may wirelessly transmit power 210 to the electronic device 201. The electronic device 201 may refer to the electronic device 101 described above. In addition, the electronic device 201 described in the following may be understood as a wireless power receiver including wireless power receiving circuitry for reception of wireless power from the wireless power transmitter 200. The wireless power transmitter 200 may transmit the power 210 to the electronic device 201 according to various charging methods.

According to various embodiments, the wireless power transmitter 200 may transmit the power 210 according to an induction method. When the wireless power transmitter 200 operates in an induction method, the wireless power transmitter 200 may include, for example, a power source, a DC-AC conversion circuit, an amplifier circuit, an impedance matching circuit, at least one capacitor, at least one coil, a communication modulation/demodulation circuit, and the like. The at least one capacitor may configure a resonance circuit together with the at least one coil. The wireless power transmitter 200 may be implemented in a manner defined, for example, by a wireless power consortium (WPC) standard (or Qi standard). The electronic device 201 for wireless reception of power may include a receiving coil, at least one capacitor, an impedance matching circuit, a rectifier, a DC-DC converter, a charger, a battery, a communication modulation/demodulation circuit, and the like.

According to various embodiments, the wireless power transmitter 200 may transmit the power 210 according to a resonance method. When operating in a resonance method, the wireless power transmitter 200 may include, for example, a power source, a DC-AC conversion circuit, an amplifier circuit, an impedance matching circuit, at least one capacitor, at least one coil, an out-band communication circuit (e.g., a Bluetooth low energy (BLE) communication circuit), and the like. The at least one capacitor and the at least one coil may configure a resonance circuit. The wireless power transmitter 200 may be implemented in a manner defined, for example, in an alliance for wireless power (A4WP) standard (or an air fuel alliance (AFA) standard). The wireless power transmitter 200 may include a coil capable of generating an induced magnetic field when a current flows based on a resonance method or an induction method.

A process in which the wireless power transmitter 200 generates an induced magnetic field may be expressed, for example, as "the wireless power transmitter 200 performs wireless transmission of the power 210". In addition, the electronic device 201 may include a coil generating an induced electromotive force due to a magnetic field, which is formed around the electronic device 201 and the magnitude of which changes according to a time. A process in which the induced electromotive force is generated through a coil may be expressed, for example, as "the electronic device 201 performs wireless reception of the power 210". The electronic device 201 may include a receiving coil, at least one capacitor, an impedance matching circuit, a rectifier, a DC-DC converter, a charger, a battery, an out-band communication circuit, and the like.

According to various embodiments, the wireless power transmitter 200 may transmit the power 210 according to an RF method. When operating in a resonance method, the wireless power transmitter 200 may include, for example, a power source, a DC-AC conversion circuit, multiple antennas, multiple amplifiers corresponding to the multiple antennas, multiple phase shifters corresponding to the multiple antennas, an out-band communication circuit (e.g., a Bluetooth low energy (BLE) communication circuit), and the like. The wireless power transmitter 200 may form an RF wave based on the location of the electronic device 201. For example, the wireless power transmitter 200 may control at least one of the phase shifter and the amplifier so as to form a beam-formed RF wave.

The wireless power transmitter 200 may include a coil capable of generating an induced magnetic field when a current flows based on a resonance method or an induction method. A process in which the wireless power transmitter 200 generates an induced magnetic field may be expressed, for example, as "the wireless power transmitter 200 performs wireless transmission of the power 210". Alternatively, the wireless power transmitter 200 may form a beam-formed RF wave according to an RF method, and this process may be expressed as "the wireless power transmitter 200 performs wireless transmission of the power 210".

In addition, the electronic device 201 may include a coil generating an induced electromotive force due to a magnetic field, which is formed around the electronic device and the magnitude of which changes according to a time. The electronic device 201 may pick up an RF wave formed around the electronic device 201. The above-described processes may be expressed as "the electronic device 201 performs wireless reception of the power 210".

The wireless power transmitter 200 according to various embodiments may perform communication with the electronic device 201. For example, the wireless power transmitter 200 may perform communication with the electronic device 201 according to an in-band method. The wireless power transmitter 200 or electronic device 201 may change a load (or an impedance) with regard to data, which is intended to be transmitted, according to an on/off keying modulation method for example. The wireless power transmitter 200 or electronic device 201 may determine on data transmitted from a counterpart device by measuring a load change (or an impedance change) based on a change in the magnitude of the current, voltage, or power of a coil. For example, the wireless power transmitter 200 may perform communication with the electronic device 201 according to an out-band method. The wireless power transmitter 200 or electronic device 201 may perform data transmission or reception using a communication circuit (e.g., a BLE communication module) provided separately from a coil or patch antenna.

In the disclosure, the wireless power transmitter 200 or electronic device 201 performing a specific operation may be understood to denote that various hardware, which are included in the wireless power transmitter 200 or electronic device 201, for example, a control circuit such as a processor, a coil, or a patch antenna, are configured to perform a specific operation. The wireless power transmitter 200 or electronic device 201 performing a specific operation may be understood as that the processor is configured to control other hardware to perform a specific operation. The wireless power transmitter 200 or electronic device 201 performing a specific operation may be understood as causing the processor or other hardware to perform a specific operation according to execution of instructions for performing the specific operation, the instructions stored in a storage circuit (e.g., a memory) of the wireless power transmitter 200 or electronic device 201.

FIG. 3 is a diagram illustrating a state in which an electronic device is placed on a charging pad for wireless charging according to various embodiments. In FIG. 3, a charging pad is illustrated as an example of the wireless power transmitter 200 of FIG. 2, and a wearable device (e.g., a smart watch) is illustrated as an example of the electronic device 201.

FIG. 3 illustrates a method in which a wireless power transmitter (e.g., a charging pad) 300 supplies power to an electronic device 301. When the electronic device 301 is placed on the wireless power transmitter 300, the electronic device 301 may perform charging through a wireless charging method using the wireless power transmitter 300. According to an embodiment, the role of the wireless power transmitter 300 illustrated in FIG. 3 may be replaced by an electronic device such as a smartphone including a battery, and in addition, various electronic devices such as a notebook computer may serve as charging pads. For example, the electronic device such as a smartphone may activate a function of "wireless power share" based on a user input. The wireless battery sharing function is a function of sharing the battery power of the electronic device, such as a smartphone, with the electronic device 301, and thus wireless power supply to the electronic device 301 is enabled. In the example illustrated in FIG. 3, although a wearable device (e.g., a smart watch) is illustrated as the electronic device 301 to be charged, various electronic devices such as wireless earphones that can be wirelessly charged by receiving relatively low power are possible, and the type of the electronic device 301 to be charged may not be limited thereto.

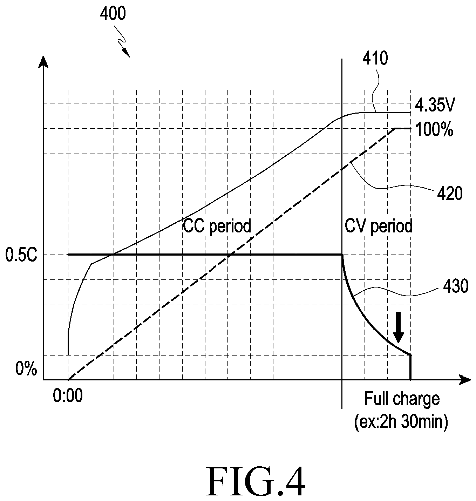

FIG. 4 is a graph 400 illustrating an example charging operation of a battery of a wearable device based on a charging current according to various embodiments.

Referring to FIG. 4, the electronic device 301 may charge a battery of the electronic device 301 with a designated first power (a first magnitude of charging power or a first constant current during a designated time). The electronic device 301 may operate in a normal charging mode including an operation of charging with a low constant current. The electronic device 301 may receive charging power required by the electronic device 301 by performing communication with the wireless power transmitter 300.

In FIG. 4, the horizontal axis represents a time, the vertical axis represents the magnitude of a charging current, and a relationship among a battery voltage 410, a charging current 430, and a charging level state 420 is illustrated in a graph form. As illustrated in FIG. 4, when performing constant current charging and constant voltage charging based on a voltage output from the wireless power transmitter 300, the electronic device 301 may perform charging with a fixed charging current (e.g., 0.5 C) in a constant current (CC) period. Thereafter, when the voltage of the battery reaches a full charge voltage (e.g., 4.35V), the charging current 430 decreases and the battery may be fully charged. For example, when charging is performed in a normal charging mode, it takes about 2 hours and 30 minutes until the charging level state 420 becomes 100%, that is, the battery is fully charged. The battery charging level 100% may be satisfied by various criteria, for example, when a battery voltage is 4.35V for example, which is equal to or greater than a designated voltage, or when a supplied current is lower than or equal to a predetermined current.

However, in recent years, an electronic device such as a smartphone may be applied with fast charging technology to provide fast battery charging during wired or wireless charging. On the other hand, in order to provide fast charging technology, it is required to increase a charging current, and since the current wearable device is worn on the user's wrist, heat generation occurs from all parts other than the efficiency due to wireless charging characteristics, and thus this may cause a risk of low-temperature burns due to skin contact.

According to various embodiments, if heat generation can be controlled while charging with a high charging current for fast charging, an electronic device such as a smart watch can be subject to fast charging. The electronic device may operate in a fast charging mode including an operation of charging with a high constant current.

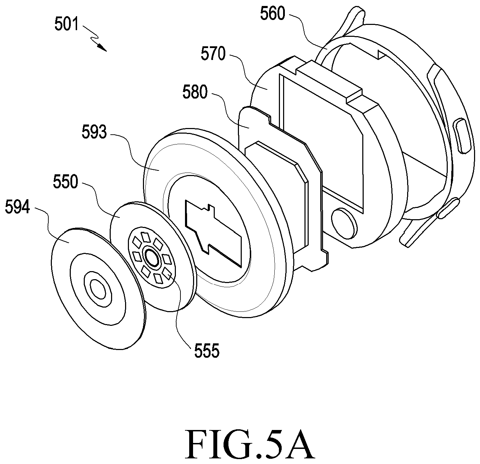

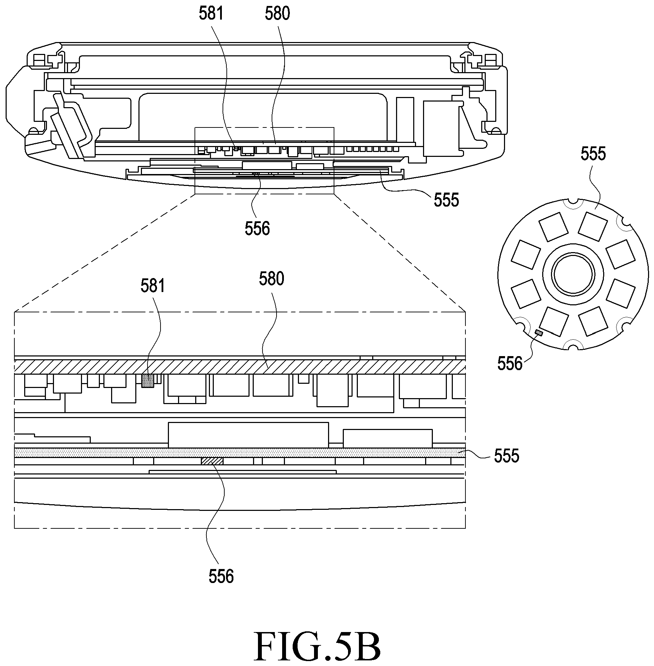

According to various embodiments, the electronic device may include at least one temperature sensor to measure a temperature during charging. According to various embodiments, the at least one temperature sensor may be disposed in an electronic device housing, which will be described referring to FIG. 5A and FIG. 5B.

FIG. 5A is an exploded perspective view illustrating an electronic device according to various embodiments, and FIG. 5B is a cross-sectional view of an electronic device according to various embodiments.

Referring to FIG. 5A and FIG. 5B, an electronic device 501 (e.g., the electronic device 201 of FIG. 2 and the electronic device 301 of FIG. 3) may include a side bezel structure (e.g., bezel) 560 and a support member (e.g., support) 570 (e.g., a bracket), a first printed circuit board 580, a second printed circuit board 555, a rear plate 593, and a rear cover 594. The support member 570 may be disposed inside the electronic device 501 and connected to the side bezel structure 560, or may be integrally formed with the side bezel structure 560. The support member 570 may be formed of, for example, a metal material and/or a non-metal (e.g., polymer) material. The support member 570 may include a display disposed on one surface thereof and a first printed circuit board 580 disposed on the other surface thereof. In an embodiment, the display may be configured to be combined with the side bezel structure 560. A processor, a memory, and/or an interface may be mounted on the first printed circuit board 580. The processor may include, for example, and without limitation, one or more of a central processor, an application processor, a graphic processing unit (GPU), an application processor sensor processor, a communication processor, or the like.

The memory may include, for example, a volatile memory or a non-volatile memory. The interface may include, for example, a high definition multimedia interface (HDMI), a universal serial bus (USB) interface, an SD card interface, and/or an audio interface. The interface may, for example, electrically or physically connect the electronic device 501 to an external electronic device, and may include a USB connector, an SD card/MMC connector, or an audio connector.

A battery (not shown) is a device for supplying power to at least one element of the electronic device 501, and may include, for example, a non-rechargeable primary cell, or a rechargeable secondary cell, or a fuel cell. At least a part of a battery (not shown) may be disposed, for example, substantially coplanar with the first printed circuit board 580 or disposed within the support member 570. A battery (not shown) may be integrally disposed inside the electronic device 501, or may be disposed detachably from the electronic device 501.

According to an embodiment, an antenna 550 may be disposed between a rear plate 593 and a rear cover 594. According to an embodiment, the antenna 550 may be disposed between a support member 570 and a rear plate 593. The antenna 550 may include, for example, and without limitation, a near field communication (NFC) antenna, a coil antenna for wireless charging, and/or a magnetic secure transmission (MST) antenna, or the like. The antenna 550 may, for example, perform short-range communication with an external device or wirelessly transmit and receive power required for charging, and may transmit a magnetic-based signal including a short-range communication signal or payment data. According to an embodiment, the antenna 550 forms an internal hole space and thus the second printed circuit board 555 may be disposed in the hole space.

According to an embodiment, the second printed circuit board 555 may be disposed between the rear plate 593 and the rear cover 594. For example, as shown in FIG. 5A, the second printed circuit board 555 may be integrally formed with the antenna 550 surrounding the second printed circuit board 555. According to an embodiment, the second printed circuit board 555 may be disposed between the support member 570 and the rear plate 593. According to various embodiments, the side bezel structure 560, the support member 570, the rear plate 593, and/or the rear cover 594 may be interpreted as a housing. For example, a housing may be formed by a structure including a side bezel structure surrounding a space between the support member 570 and the rear cover 594 of FIG. 5A. According to an embodiment, the rear plate 593 and the rear cover 594 may be integrally formed.

According to various embodiments, when the electronic device 501 includes at least one sensor module (e.g., a temperature sensor) for measuring a temperature related to heat generation during charging, the at least one sensor module may be disposed in the housing. According to an embodiment, an electronic element (e.g., a thermistor) provided as a temperature sensor may be disposed in an area adjacent to a battery (not shown) (e.g., next to a battery terminal).

According to various embodiments, a temperature sensor may include, for example, at least one thermistor circuit disposed inside the housing of the electronic device 501, and may output a temperature value based on a resistance value that changes according to temperature.

According to an embodiment, as shown in the cross-sectional view of the electronic device 501 of FIG. 5B, a first temperature sensor 581 may be disposed on the first printed circuit board 580. In addition, a second temperature sensor 556 may be disposed between the first printed circuit board 580 and the rear cover 594. According to an embodiment, as shown in FIG. 5B, a second temperature sensor 556 may be disposed adjacent to various elements such as a sub-circuit board, for example a second printed circuit board 555, disposed under the first printed circuit board 580. According to an embodiment, as shown in the front view of the second printed circuit board 555 of FIG. 5B, the second temperature sensor 556 may be disposed separately from a sensor circuit or a biometric sensor (e.g., a heart rate measurement (HRM) sensor or an electrode pad) disposed on the second printed circuit board 555. For example, when the biometric sensor is located at the center of the second printed circuit board 555, the second temperature sensor 556 may be disposed around the biometric sensor. When a user wears the biometric sensor, it may come into contact with the user's skin surface and may be exposed to the outside of the housing so as to obtain or detect the biometric signal. For example, the second temperature sensor 556 may be disposed in an area adjacent to the skin contact portion, for example, the second printed circuit board 555 so as to identify the surface heat generation temperature during fast charging.

In addition, in the above, an example in which the electronic device 501 may include two temperature sensors (e.g., 581 and 556) has been described, but this is not limited thereto. The electronic device may include multiple temperature sensors, and a temperature sensor may be disposed, for example, adjacent to a processor, or within or adjacent to elements related to charging, such as a charging circuit.

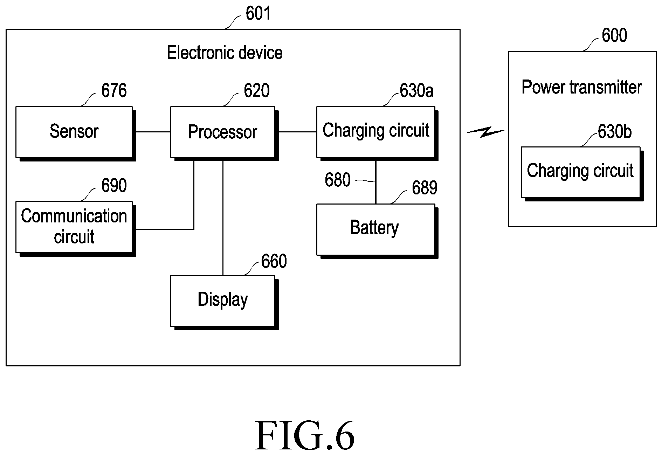

FIG. 6 is a block diagram illustrating an example configuration of an electronic device according to various embodiments.

Referring to FIG. 6, an electronic device 601 may include at least one processor (e.g., including processing circuitry) 620, a charging circuit 630a, a communication circuit 690, a display 660, at least one sensor 676, and a battery 689, and a power transmitter 600 may include a charging circuit 630b. According to an embodiment, the electronic device 601 may omit at least one of the elements or may additionally include another element(s).

A charging circuit 630b according to various embodiments may perform power transmission to the charging circuit 630a of the electronic device 601 according to various charging methods. According to an embodiment, the charging circuit 630b is an element for wired or wireless charging, and in a case of wireless charging, for example, the charging circuit may perform wireless power transmission according to at least one of, for example, and without limitation, a magnetic induction method, a resonance method, an electromagnetic wave method, or the like.

The charging circuit 630a according to various embodiments may receive power generated from the charging circuit 630b of the power transmitter 600. For example, the charging circuit 630a may include a wireless charging circuit, and may perform wireless reception of power from a wireless charging circuit of the power transmitter 600 according to at least one of a magnetic induction method, a resonance method, or an electromagnetic wave method. The charging circuit 630a may perform power processing of rectifying the received AC waveform power into a DC waveform, voltage conversion, or power regulation.

According to various embodiments, the charging circuit 630a may include a coil, a rectifying circuit, a converting circuit, and a matching circuit. For example, a coil of the charging circuit 630a may generate an induced electromotive force due to a magnetic field, which is formed around the coil and the magnitude of which changes according to a time, and accordingly, the charging circuit 630a may perform wireless power reception. In addition, a rectifying circuit may rectify the received AC waveform power. The converting circuit may adjust the voltage of the rectified power and transmit the same to a power management integrated circuit (PMIC). The charging circuit 630a may further include a regulator, or the converting circuit may be replaced by the regulator. A matching circuit may change at least one of a capacitance or a reactance of a circuit connected to the coil under the control of the processor 620, so as to allow the charging circuit 630a and the charging circuit 630b to be impedance-matched with each other.

According to various embodiments, the charging circuit 630a may perform communication with the power transmitter 600 through the communication circuit 690.

According to various embodiments, the charging circuit 630a may receive power from the power transmitter 600 and charge a battery 689 using a connector (not shown) (e.g., USB Type C).

According to various embodiments, the battery 689 may supply power to at least one element of an electronic device 601, and may be a battery 189 described above referring to FIG. 1.

According to various embodiments, a display 660 may output a charging screen. For example, a charging screen including information on the state of a battery may be output to the display 660. For example, a screen including indication information, such as a battery charge state (e.g., state of the amount of charge), whether the power transmitter 600 related to battery charge is connected, and whether battery charge occurs may be output. For example, a graphic object related to charging may be output to the display 660 using different display methods according to a charging mode such as a second charging mode (e.g., a slow charging mode, a normal charging mode, and a heat generation charging mode) or a first charging mode (e.g., a fast charging mode).

According to various embodiments, the processor 620 may be the processor 120 described above referring to FIG. 1. According to various embodiments, the processor 620 may control the overall operation of the electronic device 601, and may generate various messages required for wireless power reception during wireless charging and transmit the messages to the power transmitter 600 through a communication circuit 690.

According to various embodiments, a memory (not shown) may store an instruction for performing fast charging based on heat generation control, and may be the memory 130 described above referring to FIG. 1.

According to various embodiments, the sensor 676 may include at least one temperature sensor. According to an embodiment, the sensor 676 may include a temperature sensor (e.g., the first temperature sensor 581 of FIG. 5B) disposed in an area adjacent to a battery 689 in order to measure a temperature during charging, and a temperature sensor (e.g., the second temperature sensor 556 of FIG. 5B) disposed in an area (e.g., the second circuit board 555) adjacent to the surface of the electronic device 601.

According to various embodiments, the processor 620 may be configured to monitor, when charging is started, whether heat generation occurs or not by periodically measuring the temperature of elements relating to charging or measuring the same according to a designated condition using at least one sensor 676. The at least one sensor 676 may be connected to the processor 620, and information on the measured temperature may be transmitted to the processor 620.

For example, the processor 620 may periodically measure the temperature of the elements of the electronic device in connection with charging using at least one sensor 676, and the measurement period may be adjustable. For example, for fast charging, a charging current is required to be quickly adjusted until a battery voltage reaches a target voltage, and accordingly, the measurement period may be adjusted more quickly. In addition, when two or more sensors 676 are used, the processor 620 may detect a temperature rise through at least one of a temperature sensor disposed adjacent to the battery 689 (e.g., the first temperature sensor 581 in FIG. 5B) or a temperature sensor (e.g., the second temperature sensor 556 of FIG. 5B) disposed in an area (e.g., the second circuit board 555) adjacent to the surface of the electronic device 601. The processor 620 according to various embodiments may be configured to monitor whether heat generation occurs using both of the two temperature sensors, but even when heat generation equal to or greater than a threshold temperature is detected by either one of the temperature sensors, the processor 620 may be configured to start a control operation for lowering temperature of heat generation due to fast charging.

For example, a temperature detected by temperature sensors, which are disposed in the area adjacent to the battery 689 and the area adjacent to the surface of the electronic device 601 (e.g., the second circuit board 555) respectively, may be considered to be proportional to surface heat generation although the amount of heat transferred to the surface may differ according to the mounting structure or heat dissipation structure of the battery 689. For example, when it is desired to prevent and/or reduce surface overheating in advance to reduce the risk of low-temperature burns caused by body-skin contact, the detection of heat generation, which has a temperature equal to or higher than a threshold temperature, by either one of the temperature sensors, for example, the temperature sensor disposed in an area adjacent to the surface of the electronic device 601 (e.g., the second circuit board 555) may be prioritized.

According to various embodiments, the processor 620 may be configured to charge the battery 689 with a charging current through a charging circuit 630a. For example, a current may flow through a power supply line 680 for connection of the charging circuit 630a and the battery 689.

According to various embodiments, the processor 620 may be configured to measure a temperature associated with charging using the sensor 676. According to an embodiment, a subject for measuring a temperature may be the processor 620 and operation may be performed under the control of the processor 620.

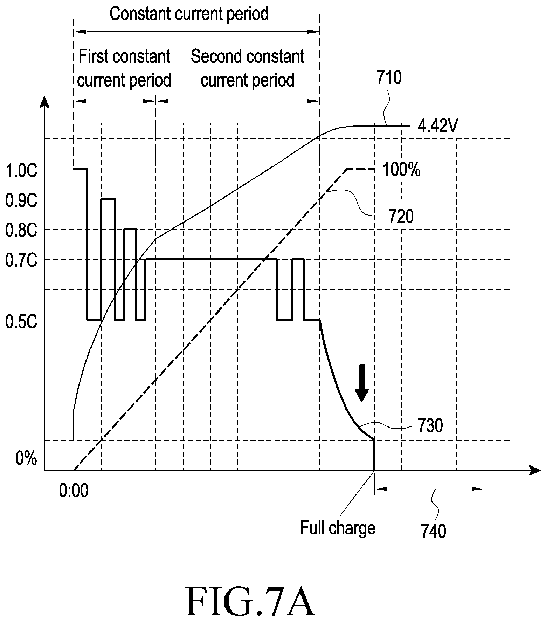

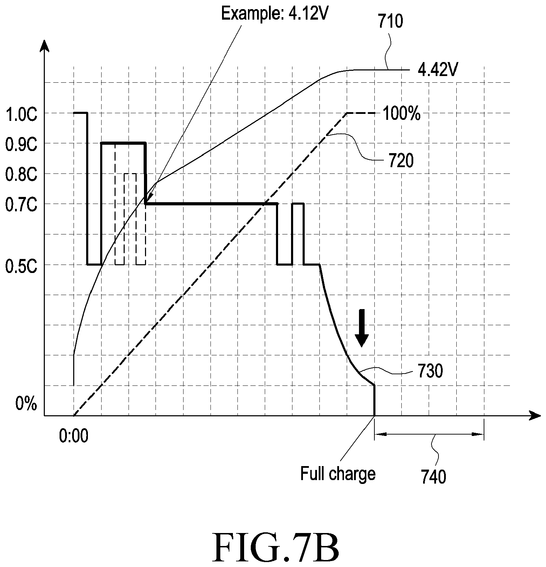

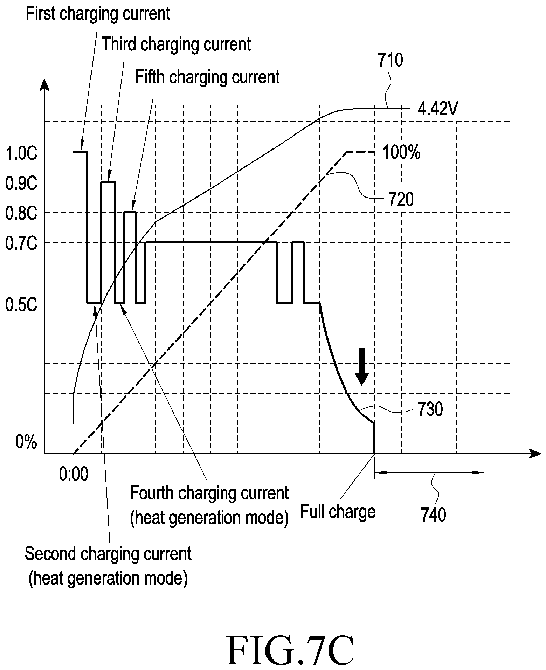

According to various embodiments, the processor 620 may adjust a charging current step by step so as to control heat generation due to fast charging in a constant current period. According to an embodiment, a constant current period may be largely divided into two periods, and a period until a battery voltage reaches a target voltage may be referred to as a first constant current period (e.g., CC1), and a period until the battery voltage reaches a full charge voltage after reaching the target voltage may be referred to as a second constant current period (e.g., CC2). Although 4.42 V is illustrated as an example of a full charge voltage in FIG. 7, the full charge voltage may be, for example, 4.35 V as in FIG. 4, and the full charge voltage may differ according to battery performance.

According to various embodiments, the processor 620 may start charging in a high charging current (e.g., a first charging current) in a constant current period for fast charging. The first charging current may have a value greater than a second charging current when temperature information associated with an electronic device is equal to or greater than a first threshold temperature (e.g., a heat generation mode), and may be the maximum allowable charging current. For example, the first charging current may be a charging current for fast charging, but may be a current configured in a state in which heat generation does not occur (e.g., a state in which a temperature is lower than a first threshold temperature or a state in which a temperature has fallen below a second threshold temperature after exceeding the first threshold temperature). On the other hand, the second charging current may be a charging current in a second charging mode. The second charging current may be a charging current for charging in a state in which heat generation occurs (e.g., a state in which a temperature is higher than a first threshold temperature (e.g., 40 °C). For example, the second charging current may be a 0.5C current which is a charging current for controlling heat generation. According to an embodiment, a first charging current corresponding to a charging current for charging in a state in which a temperature does not exceed a first threshold temperature (e.g., 40 °C) may be higher than 0.7C current.

According to various embodiments, the processor 620 may be configured to monitor the state of heat generation due to fast charging using at least one sensor 676 while performing charging with a high charging current (e.g., the first charging current) in a constant current period (e.g., CC). For example, the first charging current for fast charging may be a current of 0.7C or more. Meanwhile, monitoring related to the state of heat generation may be equally applied during wireless charging or wired charging.

According to various embodiments, the processor 620 may be configured to acquire (or measure) a temperature associated with an electronic device using at least one sensor 676 during monitoring upon wired or wireless charging, and may identify whether the temperature associated with the electronic device is higher than a first threshold temperature. For example, a first threshold temperature is a temperature indicating an overheating state and may be a reference temperature for controlling a charging current. The first threshold temperature may be a specific temperature (e.g., 40 °C) or a specific temperature range (e.g., 40 °C ~ 42 °C). For example, a temperature associated with an electronic device may not be limited to a temperature associated with battery charging, and for example, heat generation may mainly occur in the part of a charging circuit (e.g., a charger IC) rather than a battery itself. In a case of a temperature increase according to a processing load of a processor, the temperature may not be a temperature associated with battery charging.

The operation of the processor 620 as described above will be described in greater detail below with reference to FIGS. 7A, 7B and 7C. FIGS. 7A, 7B and FIG. 7C are graphs illustrating a fast charging operation of a battery of a wearable device based on a charging current according to various embodiments.

In FIGS. 7A, 7B and FIG. 7C, the horizontal axis represents a time, the vertical axis represents the magnitude of a charging current, and a relationship among a battery voltage 710, a charging level state 720, and a charging current 730 is shown in a graph form.

FIG. 7A illustrates an example in which the processor 620 repeats an operation of performing charging with a first current (e.g., a high charging current (a current configured as 0.7C or higher)) in a constant current period (e.g., CC) before a battery voltage reaches a target voltage, and performing charging with a first charging current, which is obtained by decreasing the first current to a second charging current (e.g., 0.5C) and decreasing the same by a configured value.

Thereafter, when the voltage of a battery reaches a full charge voltage (e.g., 4.42 V), a charging current 720 decreases and the battery may be fully charged. For example, when charging is performed in a fast charging mode, referring to FIG. 7A, a time taken until the state 420 (720) of a charging level becomes 100%, that is, a battery is fully charged, may be significantly decreased (indicated by reference numeral 740) compared to about 2 hours and 30 minutes of charging time in a normal charging mode having no current change as in FIG. 4, and may take, for example, about 1 hour and 50 minutes. For example, a fast charging mode may include a first charging mode for performing charging with a high charging current and a second charging mode for performing charging with a low charging current.

For example, when a temperature associated with an electronic device exceeds a first threshold temperature, for example, when the temperature falls within the specific temperature range, the processor 620 may be configured to decrease a first charging current to be a second charging current and charge a battery with the second charging current. On the other hand, when the temperature associated with the electronic device 601 does not exceed the first threshold temperature, the processor may charge the battery 689 with the first charging current while maintaining the same.

According to various embodiments, the processor 620 may be configured to perform charging with a high charging current, for example, a first charging current, as long as the temperature associated with an electronic device does not exceed a first threshold temperature in a constant current period (e.g., CC), and when the temperature reaches the first threshold temperature, the processor may decrease a first charging current to be a second charging current and perform charging with the second charging current. For example, an initial first charging current for fast charging may be 1.0C, and a second charging current may be 0.5C.

According to various embodiments, the processor 620 may be configured to continuously measure a temperature while charging the battery 689 with a second charging current, and when the temperature associated with the electronic device is below a second threshold temperature lower than the first threshold temperature, the processor may charge the battery with the first charging current decreased based on the number of times the first charging current has been decreased. According to an embodiment, the decreased first charging current may be calculated by (preconfigured decrease amount ΔI * number of times of decreases). Here, the preconfigured decrease amount (or configured value) may be changeable. For example, in case that an initial first charging current is 1.0C, when a temperature exceeds a first threshold temperature (e.g., 40 °C), the initial first charging current is decreased to be a second charging current 0.5C, and when an overheated temperature is recovered and lowered to be a second threshold temperature (e.g., 38 °C) lower than a first threshold temperature, a battery may be charged with a first charging current obtained by decreasing the initial first charging current, rather than the second charging current, by a preconfigured amount. For example, when a preconfigured decrease amount is 0.1, a decreased first charging current may be 0.9C. Thereafter, in case that a situation in which a temperature exceeds a first threshold temperature (e.g., 40 °C) occurs again while performing charging with a first charging current of 0.9C, the first charging current is decreased again to a second charging current 0.5C, and then when the temperature is recovered to the second threshold temperature (e.g., 38 °C), a battery may be charged with a charging current, which is obtained by decreasing again the decreased first charging current by a preconfigured decrease amount. Accordingly, the decreased first charging current may be 0.8C, which is a charging current obtained by performing subtraction by (-0.1 C) * 2 times.

According to various embodiments, the processor 620 may be configured to continuously measure a temperature while charging the battery 689 with a second charging current, which is decreased from a first charging current after the temperature reaches the first threshold temperature, and when the temperature associated with the electronic device 601 is below a second threshold temperature lower than the first threshold temperature, the processor may charge the battery with a charging current obtained by decreasing the first charging current step by step. Here, the processor 620 may decrease the first charging current step by step when the temperature associated with the electronic device is below the first threshold temperature, until the number of times of decreasing the first charging current step by step reaches a configured number of times (e.g., the number of times corresponding to control stage 4), and may charge the battery with the step-by-step decreased first charging current.

According to an embodiment, when a temperature associated with the electronic device 601 reaches a second threshold temperature lower than the first threshold temperature, the processor 620 may perform charging with a charging current obtained by subtracting a configured value from a first charging current and proceed to a next control stage, and may perform charging according to a first threshold temperature and a second threshold temperature until a charging power, which is obtained by performing subtraction step by step, reaches a charging current (e.g., 0.7C) corresponding to a last control stage.

For example, in control stage 1, a first charging current may be 1.0C, and the processor 620 may perform charging with a charging current of 1.0C in the control stage 1, when a temperature associated an electronic device 601, which is identified using the sensor 676, reaches a first threshold temperature (e.g., 40 °C), the processor 620 may perform charging with a second charging current of 0.5C. When charging is performed with a second charging current of 0.5C, the overheated temperature is gradually decreased, and accordingly, when a temperature associated with an electronic device is recovered to a second threshold temperature (e.g., 38 °C) through measurement, that is, when a temperature reaches the second threshold temperature (e.g., 38 °C), the processor may operate in control stage 2. Here, battery charging may be performed while maintaining the second charging current of 0.5C until a temperature is recovered to the second threshold temperature (e.g., 38 °C). Here, the second threshold temperature may be referred to as a recovery temperature.

According to an embodiment, when a temperature associated with an electronic device 601 is below a second threshold temperature (e.g., 38 °C) lower than a first threshold temperature (e.g., 40 °C) while performing charging the battery 689 with a second charging current, the processor 620 may charge the battery 689 with a charging current (e.g., 0.9C) obtained by subtracting a value (e.g., -0.1C), which is configured in response to control stage 2, from a first charging current (e.g., 1.0C). A configured value (e.g., -0.1C) is not limited to a fixed configured value, and may be, for example, a value configured by the processor 620. Meanwhile, in the above, a preconfigured decrease amount (or configured value) has been described with a fixed value, for example, -0.1C as an example, but in some cases, the value may be changed to -0.05C. In addition, for example, if the number of times of decreases is 1, -0.1C may be decreased, if the number of times of decreases is 2, -0.05C may be decreased, and if the number of times of decreases is 3, -0.03C may be decreased. As such, the decrease amount for each number of times may be different and may be a variable value.

According to an embodiment, when a temperature associated with an electronic device 601 exceeds a first threshold temperature (e.g., 40 °C), based on a result of continuous temperature measurement of the electronic device, that is, charging-related elements, while performing charging the battery 689 with a charging current corresponding to control stage 2, the processor 620 may perform charging with a second charging current of 0.5C, obtained by decreasing again a charging current (e.g., 0.9C) corresponding to the control stage 2. When the temperature associated with the electronic device is equal to or higher than the second threshold temperature while charging the battery 689 with a second charging current of 0.5C, that is, until a temperature is recovered to the second threshold temperature (e.g., 38 °C), battery charging may be performed while maintaining the second charging current of 0.5C.

According to an embodiment, when a temperature associated with an electronic device 601 is below a second threshold temperature (e.g., 38 °C) lower than a first threshold temperature (e.g., 40 °C) while charging the battery 689 with a second charging current in control stage 2, the processor 620 may charge the battery 689 with a charging current (e.g., 0.8C) obtained by subtracting a value, which is configured in response to control stage 3 (e.g., -0.1C), from a present charging current (e.g., 0.9C). Here, the charging current (e.g., 0.8C) obtained by subtracting the configured value may be a charging current corresponding to the control stage 3.

According to an embodiment, when a temperature associated with the electronic device 601 again exceeds a first threshold temperature (e.g., 40 °C), based on the result of continuous temperature measurement of the battery 689, while charging the battery 689 with a charging current (e.g., 0.8C) corresponding to control stage 3, the processor 620 may decrease the charging current (e.g., 0.8C) corresponding to the control stage 3 to be a second charging current of 0.5C and perform charging with the second charging current of 0.5C. On the other hand, as long as a temperature does not exceed a first threshold temperature (e.g., 40 °C) while charging the battery 689 with a charging current (e.g., 0.8C) corresponding to control stage 3, the charging current (e.g., 0.8C) corresponding to the control stage 3 can be maintained and thus the battery charge with the maintained charging current (e.g., 0.8C) can be continued.

According to an embodiment, when a temperature associated with an electronic device 601 is below a second threshold temperature (e.g., 38 °C) lower than a first threshold temperature (e.g., 40 °C) while charging a battery 689 with a second charging current in control stage 3, the processor 620 may charge the battery 689 with a charging current (e.g., 0.7C) obtained by subtracting a value, which is configured in response to control stage 4 (e.g., -0.1C), from a present charging current (e.g., 0.8C). Accordingly, the charging current corresponding to the control stage 4 may be 0.7C. As described above, the processor 620 may decrease the first charging current (e.g., 1.0C) by 0.1C step by step according to control stage 1-4.

According to an embodiment, when the number of times of decreasing a first charging current (e.g., 1.0C) step by step reaches a configured number of times (e.g., the number of times from control stage 1 to control stage 4), the processor 620 may charge the battery 689 with a charging current (e.g., 0.7C) corresponding to the last control stage (e.g., control stage 4) while maintaining the charging current.

As described above, when a temperature exceeds a first threshold temperature while performing charging with a high charging current for fast charging, the processor 620 may decrease the high charging current to be a second charging current and perform charge with the second charging current. Subsequently, when a temperature is recovered to the second threshold temperature by performing charging with the second charging current, the processor 620 may perform an operation of decreasing step by step a charging current for each control stage in a manner of subtracting a configured value corresponding to a control stage from the charging current. As such, when heat generation is decreased due to a second threshold temperature lower than a first threshold temperature corresponding to overheating, the processor may increase again the first charging current to be higher than the second charging current to perform fast charging.

Meanwhile, although the first charging current can be increased for fast charging due to decreased heat generation, when charging is performed with the same charging current (e.g., 1.0C) as the initial first charging current (e.g., 1.0C), a situation in which a temperature exceeds the first threshold temperature may occur frequently, and thus fast charging may be possible by decreasing the initial first charging current by a configured value (e.g., -0.1 C) and maintaining the same as long as a temperature does not exceed the first threshold temperature.

According to an embodiment, the processor 620 may perform an operation of adjusting a charging current for each control stage in a first constant current period (e.g., CC1). For example, the processor may perform an operation of adjusting a charging current for each control stage in a period before a battery voltage reaches a target voltage, that is, a period equal to or lower than the target voltage. The target voltage may be, for example, 4.12 V, this is only an example, and the numerical value of the target voltage may be configured differently. On the other hand, in a second constant current period (e.g., CC2), which is a period before the battery voltage reaches the full charge voltage (e.g., 4.42V) after reaching the target voltage, the battery 689 may be charged with a charging current (e.g., 0.7C) corresponding to the last control stage (e.g., control stage 4) while maintaining the charging current.

According to an embodiment, the processor 620 may measure a voltage of the battery while charging the battery 689 based on adjustment of the charging current for each control stage, and may identify whether the measured voltage is equal to or greater than a target voltage.

According to an embodiment, as shown in FIG. 7A, the constant current period may largely include a first constant current period and a second constant current period, and the first constant current period and the second constant current period may be distinguished based on, for example, a target voltage.

According to an embodiment, in case that the measured voltage is below the target voltage, the processor 620 may consider a period less than the target voltage as a first constant current period (e.g., CC1). Accordingly, the processor 620 may decrease the first charging current to be a second charging current and charge the battery 689 with the second charging current as described above in the first constant current period (e.g., CC1), or may charge the battery 689 with a charging current obtained by decreasing, step by step, the first charging current repeatedly as many times as the configured number of times. On the other hand, in case that the measured voltage is equal to or greater than the target voltage, the processor 620 may consider a period less than the target voltage as a second constant current period (e.g., CC2). Accordingly, the processor 620 may charge the battery while maintaining a charging current corresponding to a case in that the temperature associated with the electronic device in the second constant current period (e.g., CC2) is below the first threshold temperature and that the number of times the first charging current has been decreased step by step reaches the configured number of times.

Meanwhile, according to various embodiments, a case, in which the processor 620 repeatedly performs an operation of charging the battery with a first charging current, which is decreased step by step when the temperature associated with the electronic device is below the first threshold temperature, until the number of times the first charging current has been decreased step by step reaches the configured number of times, has been described as an example, the battery charge may be performed while controlling heat generation using a target voltage.

Referring to FIG. 7B, the processor 620 according to an embodiment may be configured to charge the battery with a designated charging current (e.g., 0.7C) when a battery voltage reaches a target voltage (e.g., 4.12V) during constant voltage charging, even if the temperature associated with the electronic device is below the first threshold temperature and the number of times the first charging current has been decreased does not reach the configured number of times. For example, in a state in which the number of times of decreases is one before reaching the target voltage, when a battery voltage reaches the target voltage (e.g., 4.12 V), the processor 620 may charge the battery with a charging current of 0.7C based on a preset amount of decreases (or a set value). According to an embodiment, even if the number of times the first charging current has been decreased does not reach the configured number of times, when a battery voltage reaches the target voltage (e.g., 4.12 V) during constant voltage charging, the processor 620 may be configured to decrease the first charging current, which is decreased in response to the number of times of decreases, to be a charging current (e.g., 0.7C) corresponding to the very last control stage.

Meanwhile, according to various embodiments, the processor 620 may identify whether heat generation control is performed or not, using the value of a charging current instead of the number of times of decreases. For example, the processor 620 may identify whether the first charging current, which is obtained by being decreased step by step, is equal to the charging current (e.g., 0.7C) corresponding to the last control stage, and may repeatedly perform the operation of charging the battery with the first charging current, which has been obtained by being decreased step by step, until the first charging current becomes equal to the charging current (e.g., 0.7 C) corresponding to the last control stage when repeatedly subtracting the value (e.g., -0.1C), which is configured in response to the control stage, from the first charging current (e.g., 1.0C).

Referring to FIG. 7C, the processor 620 according to an embodiment may be configured to measure a temperature associated with an electronic device using the sensor 676 while charging the battery with the first charging current, and when the measured temperature is equal to or higher than the first threshold temperature, the processor 620 may be configured to decrease the first charging current to be a second charging current and charge the battery with the second charging current. Here, the second charging current may be a charging current for decreasing the temperature in a heat generation state (or a heat generation mode) equal to or higher than the first threshold temperature. Therefore, when the temperature associated with the electronic device falls below the second threshold temperature lower than the first threshold temperature while performing charging with the second charging current, that is, when the heat generation is released, the battery can be charged with a third charging current lower than the first charging current. As shown in FIG. 7C, the third charging current may be a charging current lower than the first charging current.

Subsequently, when the temperature associated with the electronic device, measured using the sensor 676, while charging the battery with the third charging current, becomes again equal to or higher than the first threshold temperature, the processor 620 may be configured to decrease the third charging current to be a fourth charging current and charge the battery with the fourth charging current. In addition, when the heat generation is released, the battery may be charged with a fifth charging current lower than the third charging current. As such, a charging current can be decreased step by step, such as the first charging current, the third charging current, and the fifth charging current, so as to enable heat generation control in the constant current period and at the same time enable fast charging. Since a situation of heat generation may occur even while performing charging by decreasing a charging current step by step, when a situation in which a temperature is equal to or higher than the first threshold temperature occurs, the battery may be charged with a charging current obtained by changing the charging current to be a lower charging current such as the second charging current or the fourth charging current in order to decrease the temperature. For example, although, in FIG. 7C, an example in which the second charging current and the fourth charging current have the same current value is shown, the current value may be different from each other.

According to various example embodiments, an electronic device may include: a housing, a battery, at least one sensor, a charging circuit, and at least one processor, wherein the at least one processor is configured to: control the charging circuit to charge the battery with a first charging current through the charging circuit, measure a temperature associated with the electronic device using the at least one sensor while charging the battery with the first charging current, based on the temperature associated with the electronic device being equal to or higher than a first threshold temperature, decrease the first charging current to be a second charging current and charge the battery with the second charging current, and based on the temperature associated with the electronic device being below a second threshold temperature lower than the first threshold temperature while charging the battery with the second charging current, charge the battery with a third charging current lower than the first charging current.

According to various example embodiments, based on the temperature associated with the electronic device being equal to or higher than the first threshold temperature while charging the battery with the third charging current, the at least one processor may be configured to decrease the third charging current obtained by decreasing the first charging current step by step, to be a fourth charging current and charge the battery with the fourth charging current.

According to various example embodiments, an electronic device may include: a housing, a battery, at least one sensor, a charging circuit (e.g., a charging circuit 630a), and at least one processor, wherein the at least one processor is configured to: control the charging circuit to charge the battery with a first charging current through the charging circuit, measure a temperature associated with the electronic device using the at least one sensor while charging the battery with the first charging current, based on the temperature associated with the electronic device being equal to or higher than a first threshold temperature, decrease the first charging current to be a second charging current and charge the battery with the second charging current, and based on the temperature associated with the electronic device being below a second threshold temperature lower than the first threshold temperature while charging the battery with the second charging current, decrease the first charging current and charge the battery with the decreased charging current, and wherein the battery is configured to be charged with the first charge current decreased based on the number of times the first charge current has been decreased, the temperature associated with the electronic device being below the first threshold temperature.

According to various example embodiments, based on the temperature associated with the electronic device being equal to or higher than the first threshold temperature while charging the battery with the decreased first charging current, the at least one processor may be configured to: decrease the decreased first charging current to be the second charging current and charge the battery with the second charging current.

According to various example embodiments, the decreased first charging current may be configured as a charging current obtained by subtracting a specified value from the first charging current by the number of times the first charge current has been decreased.

According to various example embodiments, based on the temperature associated with the electronic device being equal to or higher than the second threshold temperature while charging the battery with the second charging current, the at least one processor may be configured to charge the battery with the second charging current while maintaining the second charging current.

According to various example embodiments, based on a number of times the first charging current has been decreased reaching a specified number of times, the at least one processor may be configured to charge the battery with the decreased first charging current while maintaining the decreased first charging current.

According to various example embodiments, the at least one processor may be configured to measure a voltage for the battery, and to identify whether the measured voltage is equal to or greater than a target voltage.

According to various example embodiments, based on the measured voltage being less than the target voltage, the at least one processor may be configured to: decrease the first charging current to be a second charging current and charge the battery with the second charging current, or to decrease the first charging current and charge the battery with the decreased charging current.

According to various example embodiments, the at least one processor may be configured to: charge the battery with a charging current corresponding to the temperature associated with the electronic device being below the first threshold temperature, the measured voltage being equal to or greater than the target voltage, or that number of times the first charging current has been decreased reaching a specified number of times.

According to various example embodiments, the at least one sensor may include at least one of a first temperature sensor disposed on a first printed circuit board in the housing on which the at least one processor is mounted and a second temperature sensor disposed on a second printed circuit board in the housing on which a biometric sensor is mounted.

According to various example embodiments, the at least one processor may be configured to measure a temperature associated with the electronic device using at least one of the first temperature sensor and the second temperature sensor.

According to various example embodiments, the first charging current may be a first charge corresponding to a first charging mode based on the temperature associated with the electronic device being below the first threshold temperature or the temperature associated with the electronic device being equal to or less than the second threshold temperature based on exceeding the first threshold temperature, and the second charging current may be a charging current corresponding to a second charging mode based on the temperature associated with the electronic device exceeding the first threshold temperature.

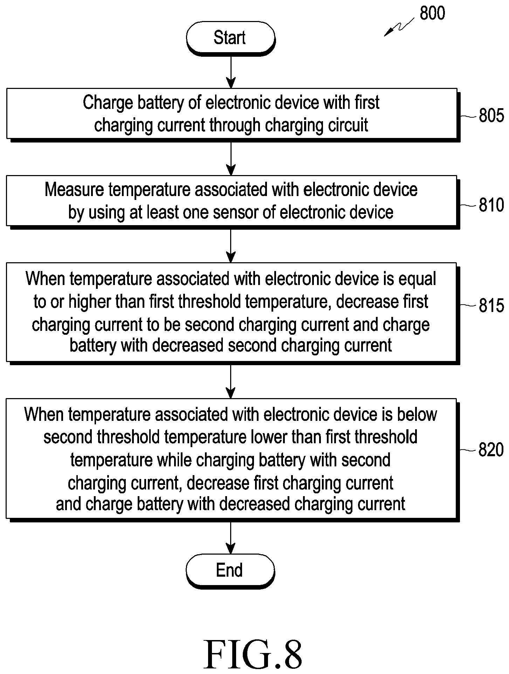

FIG. 8 is a flowchart 800 illustrating an example operation of an electronic device for performing fast charging based on heat generation control according to various embodiments.

Referring to FIG. 8, an operating method may include operations 805, 810, 815 and 820. Each stage/operation of the operating method of FIG. 8 may be performed by an electronic device (e.g., the electronic device 101 of FIG. 1, the electronic device 201 of FIG. 2, the electronic device 301 of FIG. 3, and the electronic device 601 of FIG. 6), and at least one processor of the electronic device (e.g., at least one of the processor 120 of FIG. 1 and the processor 620 of FIG. 6). In an embodiment, at least one of operations 805 to 820 may be omitted, the sequence of some operations may be changed, or another operation may be added.

In operation 805, the electronic device 601 may charge the battery 689 of the electronic device with a first charging current through a charging circuit (e.g., the charging circuit 630a). According to various embodiments, in order to perform fast charging of the battery 689, charging may be started with the charging current having maximum value at the time of wired or wireless charging.

In operation 810, the electronic device 601 may measure a temperature associated with the electronic device using at least one sensor 676 of the electronic device while charging the battery 689 with the first charging current.

In operation 815, when the temperature associated with the electronic device is equal to or higher than a first threshold temperature, the electronic device 601 may decrease the first charging current to be a second charging current and charge the battery 689 with the second charging current.

In operation 820, when the temperature associated with the electronic device corresponds to a temperature less than the second threshold temperature which is lower than the first threshold temperature, while charging the battery 689 with the second charging current, the electronic device 601 may decrease the first charging current and charge the battery 689 with the same. According to various embodiments, when the temperature associated with the battery 689 is below the first threshold temperature, the electronic device may perform an operation of charging the battery 689 with the first charging current being decreased based on the number of times of decreasing the first charging current. For example, as shown in FIG. 7A, until the number of times of decreasing the first charging current reaches a configured number of times, the operation of charging the battery with the decreased first charging current based on the number of times of decreases may be repeated. On the other hand, as shown in FIG. 7B, even if the number of times of decreasing the first charging current does not reach the configured number of times, the electronic device 601 may charge the battery with a designated charging current if a battery voltage reaches a target voltage (e.g., 4.12V) in the constant voltage period.

According to various example embodiments, the method may further include, when a temperature associated with the electronic device is equal to or higher than the first threshold temperature while charging the battery with the decreased first charging current, an operation of decreasing the decreased first charging current to be the second charging current and charging the battery with the second charging current.

According to various example embodiments, the decreased first charging current may be a charging current obtained by subtracting a configured value from the first charging current by the number of times of decreases.

According to various example embodiments, the operation of decreasing the first charging current to be the second charging current and charging the battery may include charging the battery with the second charging current while maintaining the same when the temperature associated with the electronic device is equal to or higher than a second threshold temperature while charging the battery with the second charging current.

According to various example embodiments, the method may further include charging the battery with the decreased first charging current while maintaining the same when the number of times of decreasing the first charging current reaches a configured number of times.

According to various example embodiments, the method may further include measuring a voltage of the battery and identifying whether the measured voltage is equal to or greater than a target voltage.

According to various example embodiments, the method may further include an operation of charging the battery while maintaining a charging current corresponding to a case in that the temperature associated with the electronic device is below the first threshold temperature and the measured voltage is equal to or greater than the target voltage, or a case in that the number of times of decreasing the first charging current reaches a configured number of times.

According to various example embodiments, the first charging current is a charging current corresponding to a first charging mode when a temperature associated with the electronic device is below the first threshold temperature or a temperature associated with the electronic device is below or equal to the second threshold temperature after exceeding the first threshold temperature, and the second charging current may be a charging current corresponding to a second charging mode when a temperature associated with the electronic device exceeds the first threshold temperature.

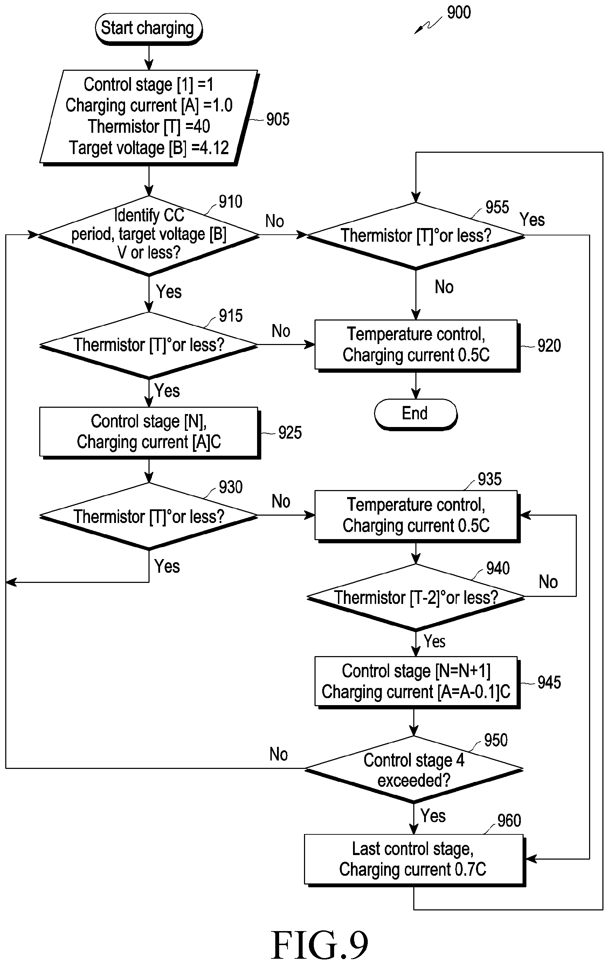

FIG. 9 is a flowchart 900 illustrating an example operation of an electronic device for fast charging when one thermistor is used according to various embodiments. In an embodiment, at least one of operations 905, 910, 915, 920, 925, 930, 935, 940, 945, 950, 955 and 960 may be omitted, the sequence of some operations may be changed, or another operation may be added.

Referring to FIG. 9, when a charging event indicating charging start occurs, the electronic device 601 may start charging. For example, when the occurrence of a charging event is detected, the electronic device 601 may identify a charging method that can be supported. According to an embodiment, the electronic device 601 may identify charging start through communication with a power transmitter 600 connected thereto or detection of a designated event signal from the power transmitter 600, and may identify a charging type such as wired charging and wireless charging, and charging-related information such as a charging method. Accordingly, the electronic device 601 may start control related to battery charging.

For example, the electronic device 601 may identify whether the charging method is a first charging method or a second charging method. According to various embodiments, the first charging method is a charging method supporting a first charging rate, the second charging method is a charging method supporting a second charging rate, and the first charging rate may be faster than the second charging rate. In the above, the first charging method supporting the first charging rate and the second charging method supporting the second charging rate have been described as an example. However, when there are multiple charging methods supportable by the electronic device 601, the electronic device may identify whether there is a third charging method supporting a third charging rate. The third charging rate may be slower than the second charging rate. For example, the first charging method may be referred to as a super-fast charging method, the second charging method may be referred to as a fast charging method, and the third charging method may be referred to as a slow charging method. In addition, in a case of the electronic device 601 supporting only the first charging method and the second charging method, the first charging method may be referred to as a fast charging method, and the second charging method may be referred to as a slow charging method.

According to various embodiments, when the charging method is a fast charging method, an initial configuration (or initial data) for the fast charging method may be input, as in operation 905. The initial configuration for the fast charging method may be initial data used for adjusting a charging current step by step based on a heat generation temperature. For example, the initial configuration (or an initial configuration value) for the fast charging method may be stored in the memory of the electronic device 601, and the initial configuration value may differ according to a charging efficiency and a charging environment. According to an embodiment, information related to the initial configuration for the fast charging method may include information in which at least one of a control stage [N], a charging current [A], a thermistor [T], or a target voltage [B] is configured. For example, the control stage is configured to adjust a charging current differently in each control stage (e.g., control stage 1 to control stage 4), and the target voltage may be a reference voltage for determining a period for controlling heat generation during fast charging (e.g., a first constant current period (CC1)). In addition, the thermistor [T] may be a threshold temperature for identifying whether overheat due to battery charging occurs.

For example, in FIG. 9, an example in which multiple control stages are largely divided into 4 stages is described, but this is only an example and is not limited to 4 stages. Further, based on a configured criterion, more control stages are possible, and the number of control stages may not be limited thereto.

According to various embodiments, in operation 905, an initial configuration may be performed such that the control stage [N] = 1, the charging current [A] = 1.0, the thermistor [T] = 40, and the target voltage [B] = 4.12.

According to various embodiments, the electronic device 601 may operate based on an initial configuration input in operation 905. In operation 910, the electronic device may identify a constant current (CC) period and identify whether a battery voltage is configured to be a target voltage (e.g., the target voltage [B] = 4.12 V) or lower. According to an embodiment, a period in which the battery voltage reaches the target voltage may be referred to as a first constant current period, and a period before the battery voltage reaches a full charge voltage (e.g., 4.42 V) after reaching the target voltage may be referred to as a second constant current period.

In response to identifying that the battery voltage is equal to or lower than the target voltage during the constant current (CC) period, the electronic device 601 may identify whether a temperature is the thermistor [T] °C (e.g., 40 °C) or less based on a result of continuous temperature measurement for the battery 689, in operation 915. For example, if a temperature does not exceed the first threshold temperature, the electronic device 601 may charge the battery 689 with the first current in a control stage [N] (e.g., a first control stage in which the control phase [N] = 1) in operation 925.

According to various embodiments, the electronic device 601 may charge the battery 689 with the first charging current in a first charging mode. For example, the first charging mode may be a mode in which battery charge is performed with a relatively high charging current (e.g., charging current [A] = 1.0) compared to a second charging current in a second charging mode. For example, the second charging current may be 0.5C, and the first charging current may be 1.0C. However, this is only an example, and the technical spirit of the disclosure may not be limited thereto.

On the other hand, for example, since overheating may occur due to communication or application execution, in this case, the electronic device may operate in the second charging mode instead of the first charging mode. Accordingly, when the result of temperature measurement for the electronic device 601 exceeds the thermistor [T] °C (e.g., 40 °C) in operation 915, the electronic device 601 may perform temperature control in operation 920. Therefore, the charging current may be 0.5C corresponding to the second charging current in the second charging mode, and the operation may be terminated when the battery charging is completed.

While charging the battery 689 with the first charging current, the electronic device 601 may identify whether the temperature associated with the electronic device 601 is equal to or less than the thermistor [T] °C (e.g., 40 °C) in operation 930. The thermistor [T] °C may be a first threshold temperature. For example, the electronic device 601 may periodically or continuously monitor whether heat generation exceeding a first threshold temperature occurs due to a high charging current in the first charging mode.

In operation 930, if the temperature associated with the electronic device 601 is not equal to or less than the thermistor [T], for example, when heat generation exceeding the first threshold temperature occurs, the electronic device 601 may perform temperature control and thus may decrease the charging current to be 0.5C in operation 935. For example, in order to rapidly lower heat generation due to a relatively high first charging current (e.g., charging current [A] = 1.0) compared to the second charging current (e.g., charging current [A] = 0.5) in the second charging mode, the electronic device 601 may decrease the first charging current (e.g., charging current [A] = 1.0) to be the second charging current (e.g., charging current [A] = 0.5) and charge the battery 689 with the second charging current.

In the heating generation situation above, an operation of significantly lowering the high charging current in order to lower the temperature may be performed. In operation 940, the electronic device 601 may identify whether the temperature associated with the electronic device 601 is equal to or less than the thermistor [T-2] °C through continuous measurement. The thermistor [T-2] °C may be a second threshold temperature (e.g., 38 °C). If the temperature associated with the electronic device 601 obtained through the continuous measurement is not equal to or below the thermistor [T-2] °C, the process returns to operation 935 and the second charging current (e.g., charging current [A] = 0.5), which is obtained by decreasing the first charging current (e.g., charging current [A] = 1.0), can be maintained.

For example, the electronic device 601 may identify whether temperature drop occurs due to a large decrease in the first charging current. If the temperature associated with the electronic device 601 is equal to or less than the thermistor [T-2] °C in operation 940, the process proceeds to a next control stage in operation 945, for example, control stage [N] = [N=N+1] and charging current [A] = [A = A-0.1].

As such, when a temperature reaches a recovery temperature, a charging current corresponding to control stage 2 may be 0.8C, which is obtained by subtracting a configured value (e.g., 0.1C) from the first charging current (e.g., 1.0C). For example, if a charging current is 1C in control stage (N=1), a charging current may be 0.9C in control stage (N=2), a charging current may be 0.8C in control stage (N=3), a charging current may be 0.7C in control stage (N=4), and a charging current may be 0.7C in control stage (N=5 or more). As described above, an example in which the charging current is subtracted by a configured value (e.g., -0.1C) according to a control stage is shown, but the configured value may differ. In addition, the configured value is not a fixed value, but the amount of decreases may differ according to a control stage. For example, if the charging current is referred to as 1C in the control stage (N=1), the charging current may be 0.9C when a value configured in the control stage (N=2) is -0.1C, the charging current may be 0.8C when a value configured in the control stage (N=3) is -0.1C, the charging current may be 0.75C when a value configured in the control stage (N=4) is -0.05C, and the charging current may be 0.7C when the stage N is 5 or more. As described above, the value configured for each control stage may be different or may be a variable value.

Meanwhile, the electronic device 601 may identify whether the control stage exceeds the control stage 4 in operation 950 during the operation of configuring the charging current for each control stage, and if the current control stage does not exceed the control stage 4, the process may return to operation 910. For example, since the current control stage corresponds to the control stage 2, the electronic device 601 may return to operation 910 and identify whether the battery voltage is equal to or less than a target voltage (e.g., target voltage [B] = 4.12 V). If the battery voltage is equal to or less than the target voltage (e.g., target voltage [B] = 4.12 V), the process proceeds operation 915, and accordingly, as long as the temperature associated with the electronic device 601 does not exceed the thermistor [T] °C (e.g., 40 °C), the above-described operations 925 to 950 may be repeatedly performed.

On the other hand, as the above operation is repeated and when the battery voltage is not less than or equal to a target voltage (e.g., target voltage [B] = 4.12 V) in operation 910, that is, when a battery voltage reaches the target voltage, the electronic device 601 may perform operation 955. In operation 955, the electronic device 601 may identify whether the temperature associated with the electronic device 601 is equal to or less than the thermistor [T] °C (e.g., 40 °C). Here, a period after reaching the target voltage (e.g., target voltage [B] = 4.12 V) may be a second constant current period (e.g., CC2). Accordingly, in operation 955, when the temperature associated with the electronic device 601 is not equal to or less than the thermistor [T] °C (e.g., 40 °C), for example, since a temperature exceeds the first threshold temperature, the electronic device may perform temperature control for lowering the temperature in operation 920, and accordingly, may perform charging with a charging current of 0.5C corresponding to the second charging current. According to an embodiment, in case that the battery voltage of the electronic device 601 reaches a target voltage (e.g., target voltage [B] = 4.12 V) and then the temperature associated with the electronic device 601 is the thermistor [T] °C (e.g., 40 °C) or less, the electronic device may perform charge with a charging current of 0.7C corresponding to the last control stage (e.g., control stage 4), in response to the second constant current section (e.g., CC2), in operation 960.

As described above, the electronic device 601 repeatedly performs an operation of charging the battery with a first charging current, which is decreased step by step when the temperature associated with the electronic device 601 is equal to or less than the thermistor [T] °C (e.g., 40 °C), until the number of times the first charging current has been decreased step by step reaches the configured number of times, and then if the current control stage reaches the control stage 4 in operation 950, the electronic device 601 may perform charging with a charging current of 0.7C corresponding to the last control stage (e.g., control stage 4) in operation 960, and as long as the temperature associated with the electronic device 601 does not exceed the thermistor [T]°C (e.g., 40°C) in operation 955 while performing charging with a charging current of 0.7C, the electronic device may perform charging while maintaining the charging current of 0.7C. On the other hand, when a temperature exceeds the thermistor [T] °C (e.g., 40 °C) in operation 955, the electronic device may perform temperature control in operation 920, and may perform charge with a second charging current of 0.5C.

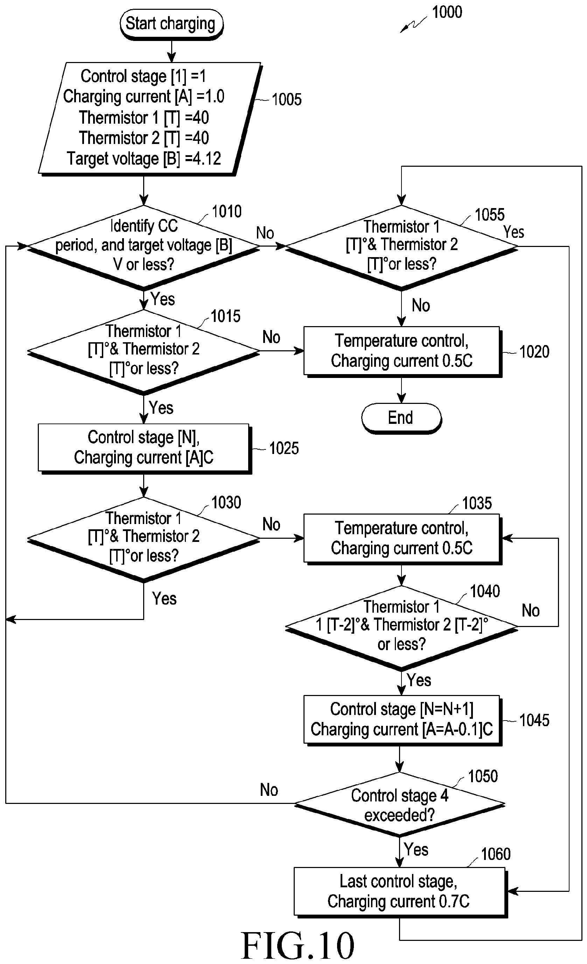

FIG. 10 is a flowchart 1000 illustrating an example operation of an electronic device for fast charging when both of two thermistors are used according to various embodiments. Since the operation in FIG. 10 is the same as or similar to that in FIG. 9, a detailed description thereof may not be repeated. However, in FIG. 10, in operations 1015, 1030, 1040, and 1055, both of two thermistors (e.g., thermistor 1 and thermistor 2) are used and a temperature associated with the electronic device 601 may be compared with each of threshold temperatures (e.g., thermistor 1 [T] and thermistor 2 [T]) determined by the thermistor 1 and the thermistor 2. Therefore, when all the results of comparison between the temperature associated with the electronic device with threshold temperatures determined by the thermistors are satisfied, an operation of adjusting a charging current for each control stage may be performed. For example, the electronic device 601 may perform the charging operation described above when a temperature, which is detected by each of a temperature sensor disposed in an area adjacent to the battery 689 and a temperature sensor disposed in an area (e.g., the second circuit board 555) adjacent to the surface of the electronic device 601, reaches the first threshold temperature and the second threshold temperature (or recovery temperature).

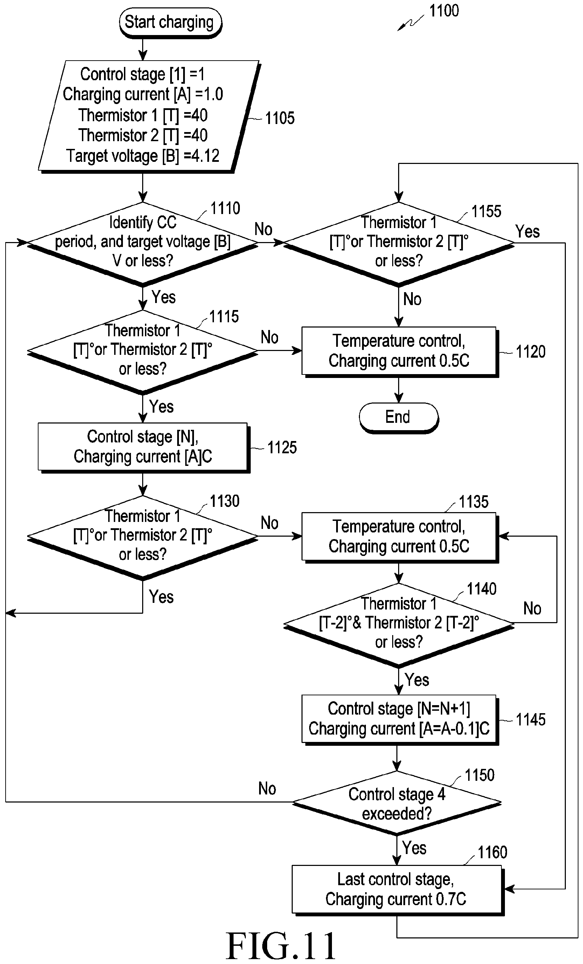

FIG. 11 is a flowchart 1100 illustrating an example operation of an electronic device for fast charging when one of two thermistors is used according to various embodiments. Since the operation in FIG. 11 is the same as or similar to that in FIG. 9, a detailed description thereof may not be repeated. However, in FIG. 11, in operations 1115, 1130, 1140, and 1155, one of the two thermistors (e.g., thermistor 1 or thermistor 2) is used and a temperature associated with the electronic device 601 may be compared with each of threshold temperatures (e.g., thermistor 1 [T] and thermistor 2 [T]) determined by the thermistor 1 and the thermistor 2. In FIG. 11, even if a result of comparison between the temperature associated with the electronic device 601 and one threshold temperature is satisfied, the operation of adjusting a charging current for each control stage may be performed. For example, the electronic device 601 may perform the charging operation described above when a temperature, which is detected by one of a temperature sensor disposed in an area adjacent to the battery 689 and a temperature sensor disposed in an area (e.g., the second circuit board 555) adjacent to the surface of the electronic device 601, reaches the first threshold temperature and the second threshold temperature (or recovery temperature).

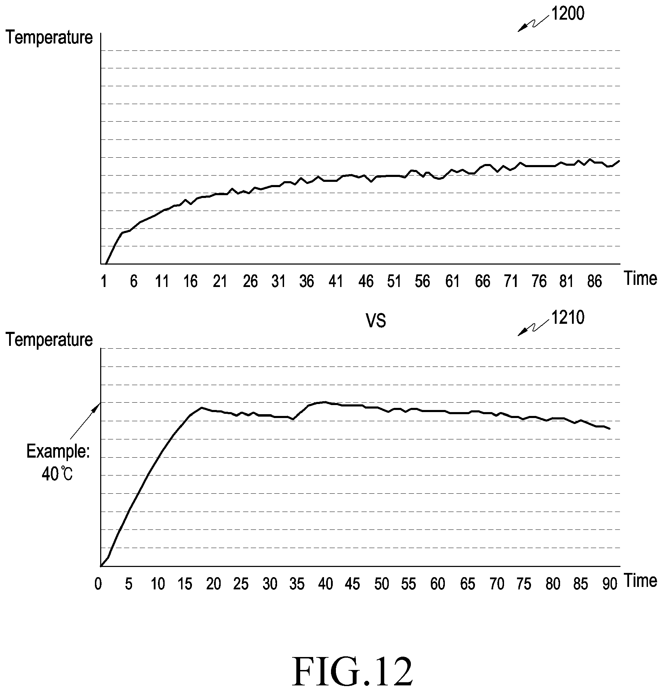

FIG. 12 is a graph illustrating a measurement result according to heat generation control during fast charging according to various embodiments.

In FIG. 12, a first surface heat generation graph 1200 in a normal charging mode and a second surface heat generation graph 1210 in a fast charging mode are compared and illustrated.

Referring to the first surface heat generation graph 1200, since charging is performed while a charging current is being maintained at, for example, 0.5C in a normal charging mode, a temperature measured in association with the electronic device may also rise gently.

On the other hand, referring to the second surface heat generation graph 1210, since charging is started with a high charging current, for example, 1.0C in a fast charging mode, even if charging is started with a charging current increased two times compared with the charging current in a normal charging mode, heat generation can be managed through temperature control without reaching a threshold temperature (or over temperature) (e.g., 40 °C). Therefore, according to various embodiments, temperature control may be performed while charging is performed with a high charging current, and thus a target charging time may be shortened compared to a charging time in the normal charging mode, so as to enable fast charging. In addition, when compared with charging with the charging current in the normal charging mode as in the first surface heat generation graph 1200, according to various embodiments, the surface heat generation temperature is increased (e.g., 2°C) as in the second surface heat generation graph 1210, and both the target charging time and the surface heat generation temperature can be controlled.

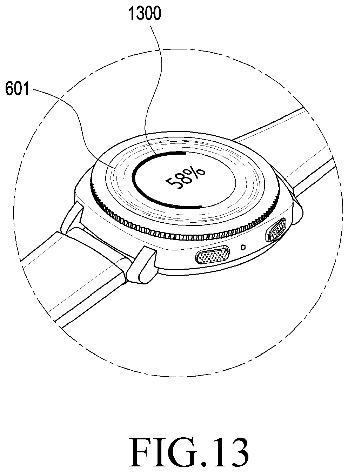

FIG. 13 is a diagram illustrating an example charging screen of an electronic device corresponding to a fast charging method according to various embodiments.

Referring to FIG. 13, although an electronic device 601 (e.g., a wearable device) has a smaller screen size than an electronic device such as a smartphone, a charging status may be output through a user interface corresponding to the screen size of the electronic device 601. For example, a graphic object that dynamically changes according to a charging method (or a charging mode) may be displayed on a circular display area of the electronic device 601.

For example, compared to a second charging mode (e.g., a slow charging mode, a normal charging mode, or a heat generation charging mode), a first charging mode (e.g., a fast charging mode) enables displaying of a quick change in color, brightness, and color effect (e.g., a gradation effect, a blinking effect) of at least one part relating to charging of the graphic object 1300. For example, an effect such as a change in speed may be expressed by adding a gradation effect to the graphic object 1300 or changing the hue, brightness, and saturation of the color of the graphic object 1300. For example, a sense of speed such as a low speed or a high speed may be expressed using a color representing a rotation speed and a high speed of a region surrounding the graphic object 1300. For example, a sense of speed may be expressed by expressing a color of a graphic object and a background color or a color surrounding a graphic object differently or displaying the graphic object blinking.

In addition, an animation effect of moving along the edge region of the circular display can be implemented. For example, the electronic device 601 such as a smart watch may be configured with various shapes, such as a circle and a square, and may display a graphic object, which dynamically changes in response to a charging method, on a display corresponding to various shapes, so as to enable a user to easily recognize various charging situations as well as to feel the charging speed.

The electronic device according to various embodiments may be one of various types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), the element may be coupled with the other element directly (e.g., wiredly), wirelessly, or via a third element.

As used in connection with various embodiments of the disclosure, the term "module" may include a unit implemented in hardware, software, or firmware, or any combination thereof, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

Various embodiments may provide a storage medium storing instructions which, when executed by at least one processor, cause the at least one processor to perform at least one operation, wherein the at least one operation includes: charging a battery of an electronic device with a first charging current through a charging circuit, measuring a temperature associated with the electronic device using at least one sensor of the electronic device while charging the battery with the first charging current, based on the temperature associated with the electronic device being equal to or higher than a first threshold temperature, decreasing the first charging current to be a second charging current and charging the battery with the second charging current, and based on the temperature associated with the electronic device being below a second threshold temperature lower than the first threshold temperature while charging the battery with the second charging current, decreasing the first charging current and charging the battery with the decreased charging current, wherein the operation of charging the battery is performed with the first charge current decreased based on the number of times the first charge current has been decreased, the temperature associated with the electronic device being below the first threshold temperature.

While the disclosure has been illustrated and described with reference to various example embodiments, it will be understood that the various example embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

## Claims

1. An electronic device comprising:
a housing;
a battery;
at least one sensor;
a charging circuit; and
at least one processor, wherein the at least one processor is configured to:
control the charging circuit to charge the battery with a first charging current through the charging circuit,
measure a temperature associated with the electronic device using the at least one sensor while charging the battery with the first charging current,
based on the temperature associated with the electronic device being equal to or higher than a first threshold temperature, decrease the first charging current to be a second charging current and charge the battery with the second charging current, and
based on the temperature associated with the electronic device being below a second threshold temperature lower than the first threshold temperature while charging the battery with the second charging current, decrease the first charging current and charge the battery with the decreased charging current, and
wherein the battery is configured to be charged with the first charge current decreased based on a number of times the first charging current has been decreased, the temperature associated with the electronic device being below the first threshold temperature.

2. The electronic device of claim 1, wherein, based on the temperature associated with the electronic device being equal to or higher than the first threshold temperature while charging the battery with the decreased first charging current, the at least one processor is configured to decrease the decreased first charging current to be the second charging current and charge the battery with the second charging current.

3. The electronic device of claim 1, wherein the decreased first charging current is configured as a charging current obtained by subtracting a specified value from the first charging current by the number of times the first charge current has been decreased.

4. The electronic device of claim 1, wherein, based on the temperature associated with the electronic device being equal to or higher than the second threshold temperature while charging the battery with the second charging current, the at least one processor is configured to charge the battery with the second charging current while maintaining the second charging current.

5. The electronic device of claim 1, wherein, based on the number of times the first charging current has been decreased reaching a specified number of times, the at least one processor is configured to charge the battery with the decreased first charging current while maintaining the decreased first charging current.

6. The electronic device of claim 1, wherein the at least one processor is configured to measure a voltage for the battery, and to identify whether the measured voltage is equal to or greater than a target voltage.

7. The electronic device of claim 6, wherein, based on the measured voltage being less than the target voltage, the at least one processor is configured to: decrease the first charging current to the second charging current and charge the battery with the second charging current, or to decrease the first charging current and charge the battery with the decreased charging current.

8. The electronic device of claim 6, wherein the at least one processor is configured to charge the battery with a charging current corresponding to the temperature associated with the electronic device being below the first threshold temperature, the measured voltage being equal to or greater than the target voltage, or the number of times the first charging current has been decreased reaching a configured number of times.

9. The electronic device of claim 1, wherein the at least one sensor comprises at least one of a first temperature sensor disposed on a first printed circuit board in the housing on which the at least one processor is mounted and a second temperature sensor disposed on a second printed circuit board in the housing on which a biometric sensor is mounted.

10. The electronic device of claim 9, wherein the at least one processor is configured to measure a temperature associated with the electronic device, using at least one of the first temperature sensor and the second temperature sensor.

11. The electronic device of claim 1, wherein the first charging current is a charging current corresponding to a first charging mode based on the temperature associated with the electronic device being below the first threshold temperature or the temperature associated with the electronic device being equal to or less than the second threshold temperature after exceeding the first threshold temperature, and the second charging current is a charging current corresponding to a second charging mode based on the temperature associated with the electronic device exceeding the first threshold temperature.

12. A charging method based on heat generation control in an electronic device, the method comprising:
charging a battery of the electronic device with a first charging current through a charging circuit;
measuring a temperature associated with the electronic device using at least one sensor of the electronic device while charging the battery with the first charging current;
based on the temperature associated with the electronic device being equal to or higher than a first threshold temperature, decreasing the first charging current to be a second charging current and charging the battery with the second charging current; and
based on the temperature associated with the electronic device is below a second threshold temperature lower than the first threshold temperature while charging the battery with the second charging current, decreasing the first charging current and charging the battery with the decreased charging current,
wherein the charging of the battery is performed with the first charge current decreased based on a number of times the first charge current has been decreased, the temperature associated with the electronic device being below the first threshold temperature.

13. The method of claim 12, further comprising: decreasing the decreased first charging current to be the second charging current and charging the battery with the second charging current based on the temperature associated with the electronic device being equal to or higher than the first threshold temperature while charging the battery with the decreased first charging current.

14. The method of claim 12, wherein the decreased first charging current is configured as a charging current obtained by subtracting a specified value from the first charging current by the number of times the first charge current is decreased.

15. **16.** The method of claim 12, wherein the decreasing the first charging current to be a second charging current and charging the battery with the second charging current comprises: charging the battery with the second charging current while maintaining the second charging current based on the temperature associated with the electronic device being equal to or higher than the second threshold temperature while charging the battery with the second charging current.
